# EUROPÄISCHE PATENTSCHRIFT

(11) **EP 2 324 544 B1**
(45) Veröffentlichungstag und Bekanntmachung des Hinweises auf die Patenterteilung: **22.01.2014**
(21) Anmeldenummer: 09753551.2
(22) Anmeldetag: 29.05.2009
(51) Int. Cl.: H01S 5/024

(54) **WÄRMEÜBERTRAGUNGSVORRICHTUNG ZUR DOPPELSEITIGEN KÜHLUNG EINES HALBLEITERBAUELEMENTES**
HEAT TRANSFER DEVICE FOR DOUBLE-SIDED COOLING OF A SEMICONDUCTOR COMPONENT
DISPOSITIF DE TRANSFERT THERMIQUE PERMETTANT LE REFROIDISSEMENT BILATÉRAL D'UN DISPOSITIF À SEMI-CONDUCTEUR

(30) Priorität: 29.05.2008 DE 102008026229
(43) Veröffentlichungstag der Anmeldung: 25.05.2011
(73) Patentinhaber: JENOPTIK Laser GmbH, 07745 Jena (DE)
(72) Erfinder: SCHRÖDER, Matthias, 07646 Stadtroda (DE); LORENZEN, Dirk, D-16798 Fürstenberg (DE)
(74) Vertreter: Grimm, Christian
(86) Internationale Anmeldenummer: PCT/DE2009/000761
(87) Internationale Veröffentlichungsnummer: WO 2009/143835

(56) Entgegenhaltungen:
- EP-A2- 1 286 441
- JP-A- 2004 146 720
- US-A- 3 303 432
- US-A- 4 393 393
- US-A1- 2002 181 523
- LORENZEN D ET AL: "Passively cooled diode lasers in the CW power range of 120-200W" PROCEEDINGS OF THE SPIE,, Bd. 6876, Nr. 68760Q, 1. Februar 2008 (2008-02-01), Seiten 68760Q-1, XP002587145 in der Anmeldung erwähnt
- S MURATA ET AL: "Theoretical and experimental evaluation of theffect of adding a heat bypass structure to a laser diode array" JAPANESE JOURNAL OF APPLIED PHYSICS, Bd. 32, 1. März 1993 (1993-03-01), Seiten 1112-1119, XP002587635 in der Anmeldung erwähnt

## Beschreibung

Die Erfindung betrifft eine Wärmeübertragungsvorrichtung mit wenigstens einem Halbleiterbauelement, insbesondere einem Laserdioden- oder Leuchtdiodenelement, nach dem Oberbegriff des Anspruches 1.

### Einleitung

In Wärmeübertragungsvorrichtungen für Halbleiterbauelemente, insbesondere Halbleiterbauelementen zur Strahlungsemission aus elektro-optischen Konversionsprozessen - insbesondere Leuchtdioden- und Laserdiodenelementen, auf die im folgenden stellvertretend für Halbleiterbauelemente Bezug genommen wird - besitzen die im Betrieb optische Strahlung emittierenden Laserdiodenelemente - epitaxie- und substratseitig stoffschlüssig befestigte, zumindest abschnittsweise elektrisch leitfähige Kontaktkörper zur elektrischen Kontaktierung. Beide Kontaktkörper dienen auch vorzugsweise der Wärmeleitung - können also auch als Wärmeleitkörper aufgefasst werden, wobei wenigstens einer der beiden Wärmeleitkörper - üblicherweise der epitaxieseitige Wärmeleitkörper - die Funktion der Wärmeableitung im wesentlichen übernimmt. Dieser dient dabei als Wärmeübertragungskörper entweder der konduktiven Kühlung und wird als durchgängiger Festkörper ausgeführt oder er dient im wesentlichen der konvektiven Kühlung, wobei kühlmitteldurchströmte Mikrokanäle im Wärmeübertragungskörper angeordnet sind. In beiden Fällen ist der wärmeübertragende Wärmeleitkörper im Betrieb des Laserdiodenelementes an eine Wärmesenke angeschlossen: im Falle der konduktiven Kühlung ist die Wärmesenke ein wärmeabsorbierender Festkörper, im Falle der konvektiven Kühlung ist die Wärmesenke das wärmeabsorbierende Fluid. Zur Verringerung des thermischen Widerstandes von Diodenlaserbauelementen kann der substratseitige Wärmeleitkörper in einem Bereich abseits des Laserdiodenelementes in stoffschlüssiger Verbindung mit dem Wärmeabfuhrkörper stehen, auf den er im wesentlichen den Teil der Wärme, den er substratseitig von dem Laserdiodenelement im Betrieb aufgenommen hat, überträgt.

### Stand der Technik

Die stoffschlüssige Verbindung zwischen dem epitaxieseitigen Wärmeabfuhrkörper und dem elektrisch leitfähigen substratseitigen Wärmeleitkörper sollte einerseits eine elektrische Isolierung aufweisen, um einen elektrische Kurzschluss des Laserdiodenelementes auszuschließen, und andererseits einen hohe thermischen Leitwert besitzen, um möglichst viel Wärme über den substratseitigen Kontaktkörper abführen zu können.
Eine erste Lösung sieht vor, eine elektrisch isolierenden Folie aus Kunststoff, beispielsweise aus Polyimid, auf der dem Lichtaustritt abgewandten Seite des Laserbarrens zwischen den epitaxieseitigen Kontaktkörper und den substratseitigen Kontaktkörper anzuordnen (EP 1 286 441 A2). Allerdings ist die thermische Leitfähigkeit dieser Kunststofffolie sehr gering und damit für einen ausreichenden Wärmeübergang vom substratseitigen zum epitaxieseitigen Körper ungeeignet.
Eine zweite Lösung bietet die Verwendung eines elektrisch isolierenden hoch wärmeleitfähigen Körpers, beispielsweise einer Aluminiumnitrid-Keramikplatte, die mit Hilfe zweier Lotschichten, beispielsweise metallischer Lotschichten, auf der dem Lichtaustritt abgewandten Seite des Laserdiodenbarrens zwischen den epitaxieseitigen Wärmeabfuhrkörper und den substratseitigen Wärmeleitkörper gelötet wird (Proc. SPIE Vol. 6876, Beitrag Nr. 68760Q).
Eine dritte Lösung, publiziert in Jpn. J. Appl. Phys. Vol. 32, pp.1112-1119 (1993), beschreibt 2 einen Wärmeabfuhrkörper, der im wesentlichen aus einem thermisch hoch leitfähigen und elektrisch isolierenden Material (hier: Siliziumkarbid) besteht und auf der Oberseite metallische Leiter zur Stromzu- und -abführung trägt. Ein Laserdiodenelement wird epitaxieseitig auf die Leiter zur Stromzuführung gelötet. Ein metallischer Wärmeleitkörper besitzt eine in einen ersten Abschnitt - Wärmeaufnahmeabschnitt genannt - eingebrachte Rechtecknut, an deren Boden das Laserdiodenelement substratseitig angelötet wird, während zwei, sich in zwei einander entgegengegengesetzten Richtungen über das Laserdiodenelemente hinaus erstreckende Abschnitte - Wärmetransferabschnitte genannt - des Wärmeleitkörpers an die stromabführenden Leiter des Wärmeabfuhrkörper gelötet werden. Vorteilhaft an den beiden letzten Lösungen ist die ausschließliche Verwendung von Komponenten relativ hoher Wärmeleitfähigkeit. Nachteilig an diesen Lösungen sind die hohen Kosten sowohl für die elektrisch isolierenden Komponenten als auch für die Lote.

Aufgabe der Erfindung ist es daher, abseits des Laserdiodenelementes eine stoffschlüssige Verbindung zwischen dem epitaxieseitigen und dem substratseitigen Kontaktkörper eines Laserdiodenelementes zu schaffen, die eine elektrische Isolierung und einen hohen thermischen Leitwert besitzt, um einen effizienten Wärmetransfer von dem substratseitigen zum epitaxieseitigen Wärmeleitkörper zu gewährleisten, und mit einer geringen Anzahl von Komponenten und Fertigungsschritten und kostengünstig herstellbar ist.

### Erfindungsbeschreibung

Die Aufgabe wird gelöst durch eine Wärmeübertragungsvorrichtung mit wenigstens einem Halbleiterbauelement, insbesondere einem Laserdioden- oder Leuchtdiodenelement, mit den Merkmalen des Anspruches 1. Bevorzugte Ausführungen sind Gegenstand der Unteransprüche.

Erfindungswesentlich ist der abseits des Laserdiodenelementes zwischen den beiden Wärmeleitkörpern liegende Fügespalt, der durch ein elektrisch isolierendes Fügemittel ausgefüllt wird, wobei ein zwischen den beiden Kontaktflächenebenen abseits des Laserdiodenelementes liegender Bereich wärmeleittähiges Metall enthält, das zu wenigstens einem der beiden Wärmeleitkörper gehört oder zu einem als Zwischenkörper ausgebildeten dritten Wärmeleitkörper, der abseits des Laserdiodenelementes zwischen den Wärmeleitkörpern angeordnet ist.
Solange die Dicke des Fügespaltes, der durch ein elektrisch isolierendes Fügemittel gefüllt ist, geringer ist als die Dicke des Laserdiodenelementes in pn-Übergangsrichtung, d. h. in Richtung der Normalen der Kontaktflächen, beziehungsweise des Abstandes der Kontaktflächen voneinander, ist der Leitwert der stoffschlüssigen Verbindung zwischen beiden Wärmeleitkörpern relativ hoch. Bevorzugt ist die Dicke des Fügespaltes geringer als die Hälfte des Kontaktflächenabstandes, besonders bevorzugt beträgt sie weniger als 20% des Kontaktflächenabstandes.
Vorteilhaft an der erfindungsgemäßen Lösung ist die Verwendung von hoch wärmeleitfähigem und kostengünstigem Metall über einen möglichst großen Abstandsbereich zwischen den Kontaktflächenebenen in Verbindung mit einer möglichst dünnen Fügezone von elektrisch isolierendem Fügemittel.
Insbesondere ermöglicht die Erfindung den völligen Verzicht auf elektrisch isolierende Bereiche im Wärmeleitkörper, was sich vorteilhaft auf eine kostengünstige Fertigung der Wärmeleitkörper auswirkt. Dieser Umstand wird durch das erfindungsgemäße Merkmal, demgemäß der erste und der zweite metallische Bereich den überwiegenden Anteil des jeweiligen Wärmeleitkörpers ausmachen, hervorgehoben. Dabei ist der Begriff "überwiegend" hinsichtlich der Masse und/ oder des Volumens des betreffenden metallischen Bereiches im Verhältnis zur Gesamtmasse beziehungsweise zum Gesamtvolumen des betreffenden Wärmeleitkörpers zu interpretieren.

Im Sinne einer besonders einfachen und kostengünstigen Fertigung erstreckt sich der jeweilige metallische Bereich vorzugsweise vollständig über seinen, ihn aufweisenden, Körper.
Ein Kurzschluss zwischen den ersten und zweiten metallischen Bereichen, die das Halbleiterbauelement auf einander gegenüberliegenden Seiten kontaktieren, kann damit vorteilhafterweise allein durch das elektrisch isolierende Fügemittel unterbunden werden, wodurch sich ein sehr einfacher, kompakter und kostengünstiger Aufbau ergibt.

Dabei gilt das Volumen eines metallhaltigen Verbundwerkstoffes auch dann als metallischer Bereich, wenn er elektrisch isolierende oder isolierte Partikel enthält, weil der Verbundwerkstoff makroskopisch metallische Eigenschaften - insbesondere die erfindungswesentliche elektrische Leitung - aufweist. Diese Argumentation trifft insbesondere auf Metall-Matrix-Komposit-Werkstoffe zu, in denen Partikel von Kohlenstoff, Siliziumkarbid oder Bornitrid in Metall (Kupfer, Silber, Aluminium usw.) eingebettet sind. Jeder metallische Bereich kann zudem sowohl einen einzigen metallischen Werkstoff als auch eine Kombination mehrerer verschiedener metallischer Werkstoffe aufweisen, die beispielsweise in mehreren Schichten vorliegen.

Der erfindungsgemäß zwischen den Kontaktflächenebenen angeordnete metallische Bereich kann dem ersten metallischen Bereich, das heißt dem ersten Wärmeleitkörper, zugeordnet sein und/ oder dem zweiten metallischen Bereich, das heißt dem zweiten Wärmeleitkörper, und/ oder einem dritten metallischen Bereich eines Zwischenkörpers, der zumindest abschnittsweise zwischen den ersten und zweiten Wärmetransferabschnitten angeordnet ist.
Der dritte metallische Bereich kann mit einer der Kontaktflächen des Laserdiodenelementes in elektrisch leitfähiger Verbindung stehen, beispielsweise vermittels einer der metallischen Bereiche der Wärmeleitkörper. Dies ist jedoch nicht zwingend. Er kann ebenso - weniger bevorzugt - durch zwei auf einander gegenüberliegenden Seiten des Zwischenkörpers angeordneten Schichten von elektrisch isolierendem Fügemittel elektrisch von beiden metallischen Bereichen der Wärmeleitkörper und damit vom Laserdiodenelement getrennt sein.
Der Vorteil der Verwendung eines Zwischenkörpers, der vorzugsweise vollständig metallisch ist, besteht darin, dass die Wärmeeintrittsflächen der Wärmeaufnahmeabschnitte der Wärmeleitkörper zusammen mit den Wärmetransferflächen der Wärmetransferabschnitte gemeinsam in einem einzigen Oberflächenbearbeitungsprozess - beispielsweise durch Diamantfräsen - hocheben hergestellt werden können.

Erfindungsgemäß überbrückt das elektrisch isolierende Fügemittel in wenigstens einem Teilbereich des Fügespalts den dortigen Abstand zwischen dem metallischen Bereich zumindest eines der Wärmeleitkörper und wenigstens einem weiteren metallischen Bereich wenigstens zur Hälfte stoffschlüssig. Vorzugsweise überbrückt das elektrisch isolierende Fügemittel den Abstand zumindest annähernd vollständig, wobei die von einer vollständigen Überbrückung bestehenden Abweichungen aus der Verwendung dünner Haftvermittlungsschichten, beispielsweise einer Grundierung, herrühren können.

Für die stoffschlüssige Verbindung in Frage kommende elektrisch isolierende Fügemittel sind beispielsweise elektrisch isolierende Klebstoffe, gefüllt mit wärmeleitenden elektrisch isolierenden Partikeln oder ungefüllt, Zemente und Glaslote.

Vorzugsweise enthält die Wärmeübertragungsvorrichtung nicht mehr als zwei Wärmeleitkörper, von denen sich wenigstens einer bis zwischen die Kontaktflächenebenen abseits des Laserdiodenelementes erstreckt, und wobei der metallische Bereich des ersten Wärmeleitkörpers in elektrischer Verbindung mit der ersten Kontaktfläche steht und der metallische Bereich des zweiten Wärmeleitkörpers in elektrischer Verbindung mit der zweiten Kontaktfläche steht.

Vorzugsweise sind die Wärmeleitkörper auf makroskopischer Größenordnung vollständig elektrisch leitfähig. Beispielsweise können sie überwiegend aus einem hochwärmeleitfähigen Diamant-Metall-Verbundwerkstoff bestehen. In einer besonders kostengünstigen Variante bestehen die Wärmeleitkörper überwiegend oder im wesentlichen vollständig aus Kupfer.
Vorzugsweise sind die Wärmeleitkörper plattenfömig ausgebildet.
Zur Gewährleistung eines hohen thermischen Leitwertes der Wärmeleitplatten ist die Dicke der Platten vorzugsweise größer als die Resonatorlänge oder als die Breite des Laserdiodenelementes.
Zur Gewährleistung eines hohen thermischen Leitwertes der Fügezone ist die flächenmäßige Ausdehnung der Fügezone größer als die parallele flächenmäßige Ausdehnung des Laserdiodenelementes.

Bei Laserdiodenbarren liegt die elektrisch isolierende Fügezone bevorzugt auf von der frontseitigen Lichtemissionsfläche abgewandten Rückseite. Bei Einzelemitter-Laserdioden liegen zwei elektrisch isolierende Fügezonen bevorzugt seitlich in zur optischen Achse der Lichtemission senkrecht und zu den Kontaktflächen parallel orientierter Richtung der Laserdioden.

Zur Wärmeabfuhr kann wenigstens einer der beiden Wärmeableitkörper an eine Wärmesenke angeschlossen sein. Vorzugsweise ist aus Kostengründen nur einer der beiden Wärmeableitkörper an eine Wärmesenke angeschlossen. Im Falle konduktiver Kühlung ist diese Wärmesenke ein Wärmeaufnahmekörper, welcher auf der dem Laserdiodenelement gegenüberliegenden Seite des betreffenden Wärmeleitkörpers angeordnet ist.
Eine doppelseitige Kühlung des Halbleiterbauelementes wird erfindungsgemäß auch durch eine einzige, an nur einem Wärmeleitkörper angebrachte, Wärmesenke realisiert, weil der andere Wärmeleitkörper (ohne zusätzliche Wärmsenke) in seiner Funktion als thermischer Nebenschluss (engl.: thermal bypass) zu einer Kühlung beiträgt.
Prinzipiell jedoch wird der thermische Aspekt der Erfindung immer dann wirksam, wenn die thermischen Widerstände zweier Wärmesenken, die an verschiedenen Wärmeleitkörpern befestigt sind, derart unterschiedlich sind, dass sich ein effektiver Wärmefluss von dem Wärmeleitkörper mit der Wärmesenke des höheren thermischen Widerstands zu dem Wärmeleitkörper mit der Wärmesenke des niedrigeren thermischen Widerstands ergibt.

Der über alles herausragende Vorteil der Erfindung liegt zusammengefasst darin, mit einem Minimum an Komponenten (Halbleiterbauelement, Wärmeleitkörper 1, Wärmeleitkörper 2) eine doppelseitige Kühlung des Halbleiterbauelementes realisieren zu können. Damit wird ein Maximum an Kühleffizienz pro Kostenaufwand erzielt.
Vorzugsweise weist daher ein erfindungsgemäßes Diodenlaserbauelement mit einem Laserdiodenbarren als Halbleiterbauelement abgesehen von einer Wärmesenke keine weiteren, für die Wärmeleitung relevanten Komponenten auf als nur den ersten und zweiten Wärmeleitkörper. Zu den für eine Wärmeleitung nicht relevanten Komponenten zählen Befestigungsmittel zur Anbringung elektrischer Anschlüsse, Kurzschlusselemente und Temperatursensoren.

Nachfolgend wird die Erfindung anhand von Ausführungsbeispielen näher erläutert. Dazu zeigen
Fig. 1a eine Seitenansicht auf die Bauteile eines ersten Ausführungsbeispieles der erfindungsgemäßen Wärmübertragungsvorrichtung,
Fig. 1b eine Seitenansicht auf eine erste Variante des ersten Ausführungsbeispieles der erfindungsgemäßen Wärmübertragungsvorrichtung,
Fig.1c eine Seitenansicht auf eine zweite Variante des ersten Ausführungsbeispieles der erfindungsgemäßen Wärmübertragungsvorrichtung,
Fig. 1d eine Seitenansicht auf eine dritte Variante des ersten Ausführungsbeispieles der erfindungsgemäßen Wärmübertragungsvorrichtung,
Fig. 2a eine Seitenansicht auf die Bauteile einer ersten Variante eines zweiten Ausführungsbeispieles der erfindungsgemäßen Wärmübertragungsvorrichtung,
Fig. 2b eine Seitenansicht auf die erste Variante des zweiten Ausführungsbeispieles der erfindungsgemäßen Wärmübertragungsvorrichtung,
Fig. 2c eine Seitenansicht auf eine zweite Variante des zweiten Ausführungsbeispieles der erfindungsgemäßen Wärmübertragungsvorrichtung und
Fig. 2d eine Seitenansicht auf eine dritte Variante des zweiten Ausführungsbeispieles der erfindungsgemäßen Wärmübertragungsvorrichtung.

Alle Ausführungsbeispiele repräsentieren Diodenlaserbauelemente mit einem Laserdiodenbarren. Nichtsdestoweniger können sie auch Strahlungsquellen mit einem oder mehreren nebeneinander angeordneten Einzel- oder Mehrfachemitterlaserdioden oder Einzel- oder Mehrfachemitterleuchtdioden oder Leuchtdiodenbarren repräsentieren. Darüber hinaus ist die Wärmeübertragungsvorrichtung auch zur Kühlung von Halbleiterschaltelementen, beispielsweise Hochleistungstransistoren, Hochleistungsthyristoren usw. geeignet.

### Ausführungsbeispiel 1

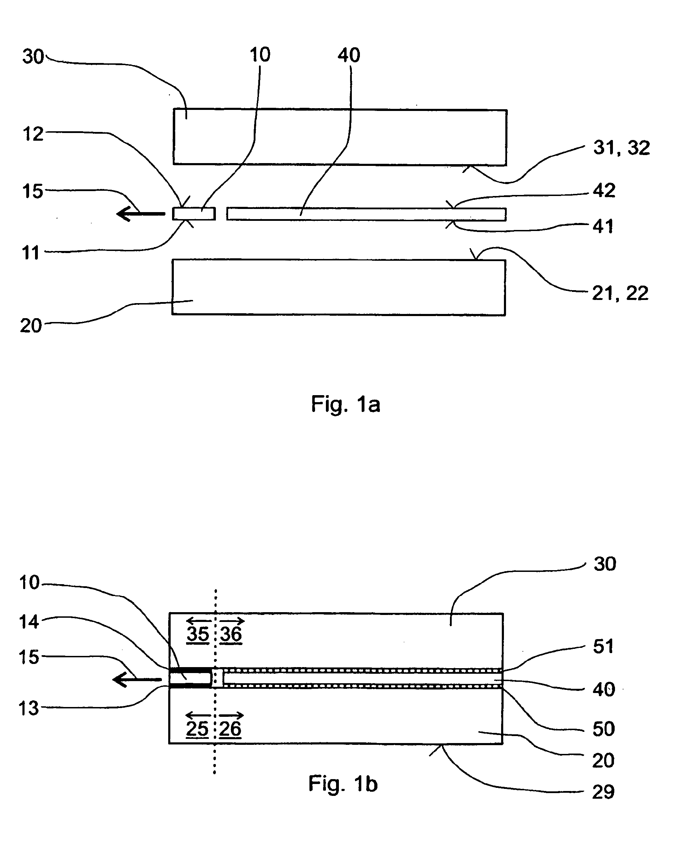

Die für die Herstellung einer ersten Variante des ersten Ausführungsbeispieles der erfindungsgemäßen Wärmeübertragungsvorrichtung verwendeten Bauelemente sind in Fig. 1a: dargestellt: Der Laserdiodenbarren 10 weist eine erste, epitaxieseitige Kontaktfläche 11 zur elektrischen Kontaktierung auf sowie eine zweite, substratseitige Kontaktfläche 12, die der epitaxieseitigen Kontaktfläche gegenüberliegt. Der Laserdiodenbarren besitzt eine Resonatorlänge von 2mm. Die im Betrieb erfolgende Lichtemission ist durch den Pfeil 15 gekennzeichnet, der auf einer optischen Achse angeordnet ist. In der Lichtemission entgegengesetzter Richtung ist eine überwiegend aus Kupfer bestehende Metallplatte 40 von 110µm Dicke hinter dem 120µm dicken Laserdiodenbarren angeordnet. Sie besitzt einander gegenüberliegende epitaxie- und substratseitig orientierte Wärmeübergangsflächen 41 und 42. Ein erster, epitaxieseitiger, plattenförmiger Wärmeleitkörper 20 besteht überwiegend aus Kupfer und weist eine der epitaxieseitigen Kontaktfläche 11 gegenüberliegenden Wärmeeintrittsfläche 21 auf sowie eine Wärmetransferfläche 22, die der epitaxieseitigen Wärmeübergangsfläche 41 der Metallplatte 40 gegenüberliegt. Seine Dicke beträgt 4mm.

Ein zweiter, substratseitiger, plattenförmiger Wärmeleitkörper 30 besteht ebenfalls überwiegend aus Kupfer und weist eine der substratseitigen Kontaktfläche 12 gegenüberliegenden Wärmeeintrittsfläche 31 auf sowie eine Wärmetransferfläche 32, die der substratseitigen Wärmeübergangsfläche 42 der Metallplatte 40 gegenüberliegt. Seine Dicke beträgt ebenfalls 4mm.
In Vorbereitung der Einrichtung eines Stoffschlusses dieser Komponenten 10, 20, 30, 40 zur Ausbildung der ersten Variante der ersten Ausführungsbeispieles wird der epitaxieseitige Wärmeleitkörper 20 im Bereich der epitaxieseitigen Wärmeeintrittsfläche 21 mit Indiumlot 13 beschichtet. Analog wird der substratseitige Wärmeleitkörper 30 im Bereich der substratseitigen Wärmeeintrittsfläche 31 mit Indiumlot 14 beschichtet.
Ferner wird auf die epitaxieseitige Wärmetransferfläche 22 des epitaxieseitigen Wärmeleitkörpers 20 eine Schicht elektrisch isolierenden Klebstoffs 50 aufgebracht. Analog wird auf die substratseitige Wärmetransferfläche 32 des substratseitigen Wärmeleitkörpers 30 eine Schicht elektrisch isolierenden Klebstoffs 51 aufgebracht.
Zur Einrichtung des Stoffschlusses der Komponenten 10, 20, 30, 40 wird, wie in Fig. 1b gezeigt, der Laserdiodenbarren 10 zwischen dem ersten und zweiten Wärmeleitkörper 20, 30 epitaxieseitig und substratseitig in Kontakt mit den jeweiligen Lotschichten gebracht und die Metallplatte 40 zwischen dem ersten und zweiten Wärmeleitkörper 20, 30 in Kontakt mit den jeweiligen Klebstoffschichten 50 und 51. Alle Komponenten durchlaufen anschließend ein Temperaturprofil, das sowohl geeignet ist, eine hochwertige Lötverbindung 13 zwischen dem Laserdiodenbarren 10 und einem epitaxieseitigen Wärmeaufnahmeabschnitt 25 des epitaxieseitigen Wärmeleitkörpers 20, als auch eine hochwertige Lötverbindung 14 zwischen dem Laserdiodenbarren 10 und einem substratseitigen Wärmeaufnahmeabschnitt 35 des substratseitigen Wärmeleitkörpers 30, als auch eine hochwertige Klebeverbindung 50 zwischen der Metallplatte 40 und einem sich entgegen Lichtemissionsrichtung 15 über den Laserdiodenbarren 10 hinaus erstreckenden epitaxieseitigen Wärmetransferabschnitt 26 des epitaxieseitigen Wärmeleitkörpers 20, als auch
eine hochwertige Klebeverbindung 51 zwischen der Metallplatte 40 und einem sich entgegen Lichtemissionsrichtung 15 über den Laserdiodenbarren 10 hinaus erstreckenden substratseitigen Wärmetransferabschnitt 36 des epitaxieseitigen Wärmeleitkörpers 30 zu erzielen.
Zum Betrieb des Laserdiodenbarrens in der Wärmeübertragungsvorrichtung wird eine Wärmesenke an einer vom Laserdiodenbarren 10 und der Metallplatte 40 abgewandten Seite 29 des epitaxieseitigen Wärmeleitkörpers 20 befestigt, ein erster elektrischer Anschluss am epitaxieseitigen Wärmeleitkörper 20 und ein zweiter elektrischer Anschluss am substratseitigen Wärmeleitkörper 30.

Beim Betrieb des Laserdiodenbarrens wird die in der aktiven Zone erzeugte Wärme zu einem ersten Teil über die epitaxieseitige Kontaktfläche 11, die epitaxieseitige Lotfuge 13 und die epitaxieseitige Wärmeeintrittsfläche 21 vom epitaxieseitigen Wärmeaufnahmeabschnitt 25 des epitaxieseitigen Wärmeleitkörpers 20 aufgenommen und zumindest teilweise in den epitaxieseitigen Wärmetransferabschnitt 26 hinein gespreizt. Zu einem zweiten Teil wird die Wärme über die substratseitige Kontaktfläche 12, die substratseitige Lotfuge 14 und die substratseitige Wärmeeintrittsfläche 31 vom substratseitigen Wärmeaufnahmeabschnitt 35 des substratseitigen Wärmeleitkörpers 30 aufgenommen und zumindest nahezu vollständig in den substratseitigen Wärmetransferabschnitt 36 hinein geleitet. Aus dem substratseitigen Wärmetransferabschnitt 36 wird der zweite Wärmeteil über die substratseitige Wärmetransferfläche 32, den elektrisch isolierenden Klebespalt 51, die substratseitige Wärmeübergangsfläche 42, die Metallplatte 40, die epitaxieseitige Wärmeübergangsfläche 41, den elektrisch isolierenden Klebespalt 50 und die epitaxieseitige Wärmetransferfläche 22 in den epitaxieseitigen Wärmetransferabschnitt 26 des epitaxieseitigen Wärmeleitkörpers 20 überführt und dort mit dem ersten Wärmeteil vereinigt. Die Wärme wird dann über die Anbindungsfläche 29 zur Wärmeabfuhr an einen Wärmesenkenkörper abgegeben.
Die Klebefugen 50 und 51 sorgen für eine elektrische Isolierung zwischen den Wärmeleitkörpern 20 und 30, zwischen denen für den Betrieb des Laserdiodenbarrens eine entsprechende Potentialdifferenz bestehen muss. Da die Dicke der Metallplatte 40 nur geringfügig kleiner ist als die des Laserdiodenbarrens, ist auch die Dicke der Klebefugen 50 und 51 sehr gering, beispielsweise jeweils 10 µm. Trotz einer niedrigen Wärmeleitfähigkeit des elektrisch isolierenden Klebstoffes bleibt daher unter Berücksichtigung der hohen thermischen Leitfähigkeit der Metallplatte 40 der thermische Leitwert des Wärmeübergangs vom substratseitigen Wärmetransferabschnitt 36 zum epitaxieseitigen Wärmetransferabschnitt 26 gering.
Damit kann tatsächlich der substratseitige Wärmeleitkörper zur doppelseitigen Kühlung des Laserdiodenbarrens effizient genutzt werden.

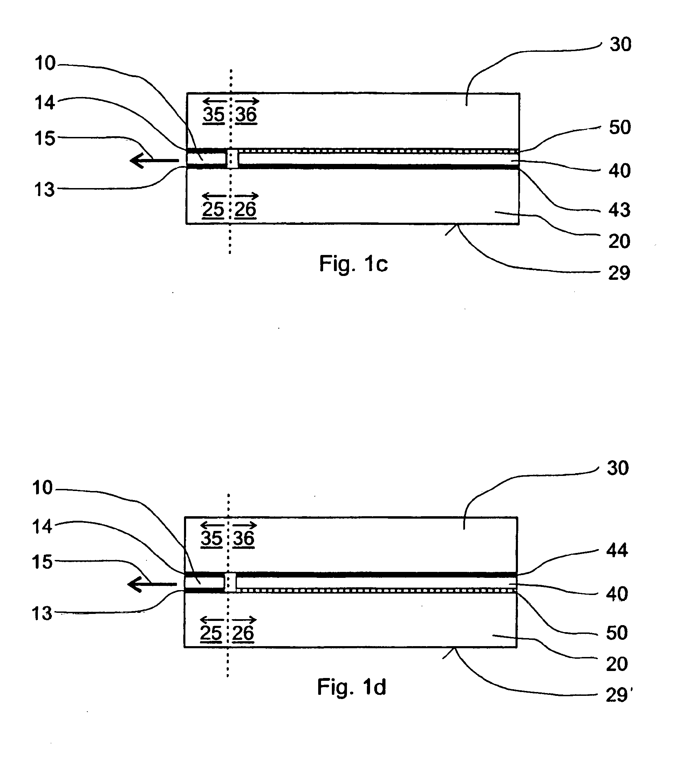

In einer in Fig. 1c dargestellten zweiten Variante des ersten Ausführungsbeispieles bestehen der epitaxieseitige und der substratseitige Wärmeleitkörper 20 und 30 überwiegend aus einem Diamant-Silber-Verbundwerkstoff, dessen thermischer Ausdehnungskoeffizient dem des Laserdiodenbarrens 20 zumindest annähernd entspricht. Auf die epitaxieseitige Wärmeeintrittsfläche 21 wird eine Gold-Zinn-Lotschicht 13 aufgebracht, auf die epitaxieseitige Wärmetransferfläche 22 eine Gold-Zinn-Lotschicht 43. In einem ersten Fügeprozess werden gleichzeitig der Laserdiodenbarren 10 epitaxieseitig und die Metallplatte 40, die überwiegend aus einem Kupfer-Molybdän-Verbundwerkstoff besteht, auf den epitaxieseitigen Wärmeleitkörper 20 gelötet.
Auf die substratseitige Wärmeeintrittsfläche 31 wird eine Zinn-Lotschicht 14 aufgebracht, auf die substratseitige Wärmetransferfläche 32 eine Schicht elektrisch isolierenden Klebstoff 50, der zur
Erhöhung seiner Wärmeleitfähigkeit mit Aluminiumoxidpartikeln gefüllt ist. In einem zweiten Fügeprozess wird der substratseitige Wärmeaufnahmeabschnitt 35 substratseitig an den Laserdiodenbarren 10 gelötet und der substratseitige Wärmetransferabschnitt an der Metallplatte durch thermisch bedingte Aushärtung angeklebt.
Diese zweite Variante des ersten Ausführungsbeispieles besitzt den Vorteil, dass eine Klebstoffschicht durch eine metallische Lotschicht mit einer höheren Wärmeleitfähigkeit als die der Klebstoffschicht ersetzt wurde.

Die in Fig. 1d dargestellte dritte Variante des ersten Ausführungsbeispiels unterscheidet sich von der zweiten Variante dadurch, dass in einem ersten Fügeprozess die Kupfer-Molybdän-Platte 40 mittels eines Zementes 50 auf dem epitaxieseitigen Wärmeleitkörper 20 befestigt wird. Alternativ kann anstatt des Zementes 50 auch ein Glaslot 50 verwendet werden. Die an ihren Wärmeeintrittsflächen 21, 31 mit einer Gold-Zinn-Lotschicht versehenen Wärmeleitkörper werden unter Einbringung einer Folie einer Gold-Zinn-Lot-Vorform in einem zweiten Fügeprozess sowohl mit dem Laserdiodenbarren 10 als auch mit der Kupfer-Molybdän-Platte 40 stoffschlüssig verbunden. Die dritte Variante besitzt den Vorteil einer beidseitigen hoch zuverlässigen Gold-Zinn-Lötung des Laserdiodenbarrens, der dadurch ermöglicht wird, dass im Gegensatz zu Klebstoffen ein hochtemperaturunempfindliches elektrisch isolierendes Fügemittel verwendet wird.

### Ausführungsbeispiel 2

Im Gegensatz zu den Varianten des ersten Ausführungsbeispieles kommen die Varianten des zweiten Ausführungsbeispieles ohne die Verwendung einer zwischen die Wärmeleitkörper gebrachten Metallplatte 40 aus. Statt dessen wird wenigstens einer der Wärmeleitkörper 20, 30 mit einer Erhebung im Bereich des Wärmetransferabschnittes 26, 36 versehen, der sich in der stoffschlüssigen Wärmeübertragungsvorrichtung bis in die rückwärtige Flucht des Laserdiodenbarrens 10, das heißt bis zwischen die beiden Kontaktflächenebenen, erstreckt. Damit liegen die Wärmeeintrittsfläche 21, 31 und die Wärmetransferfläche 22, 32 in zueinander parallel versetzten Ebenen.

Die Varianten des zweiten Ausführungsbeispieles kommen im Gegensatz zu denen des ersten Ausführungsbeispieles mit einem Minimum an Komponenten aus.

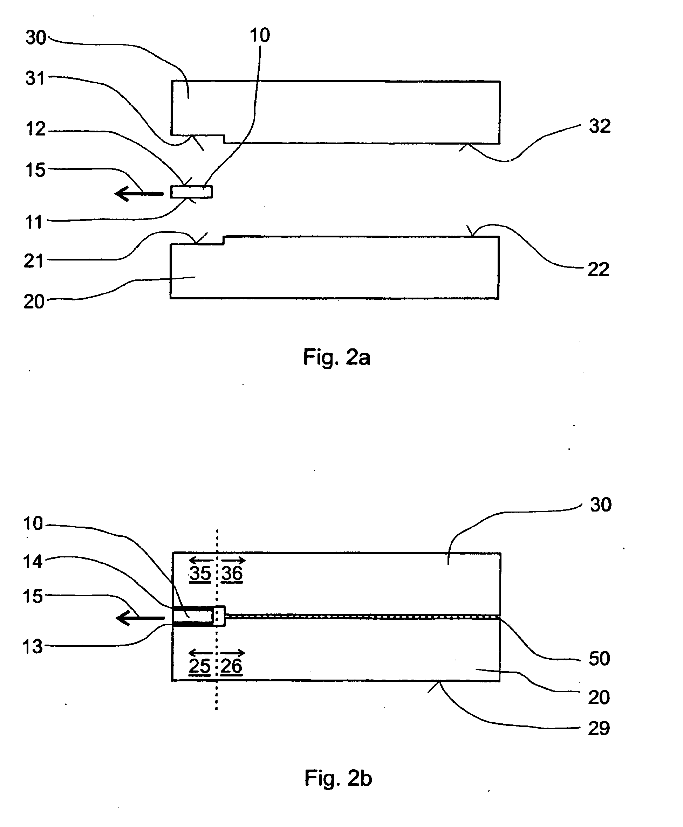

Die Komponenten der ersten Variante des zweiten Ausführungsbeispieles sind in Figur 2a dargestellt. Die Wärmeleitkörper 20 und 30 bestehen überwiegend aus Kupfer. Die Wärmeeintrittsflächen 21 und 31 sind am Boden von Ausnehmungen in den Wärmeaufnahmeabschnitten 25 und 35 gegenüber den Wärmetransferflächen 22 und 32 in den Wärmetransferabschnitten 26 und 36 um 50µm parallel in vom Laserdiodenbarren fortweisender Richtung versetzt. Das Paar von Ausnehmungen bietet, wie in Fig. 2b veranschaulicht, Raum zur Aufnahme des Laserdiodenbarrens 10, welcher mit Indiumlot 13 und 14 stoffschlüssig in einem einzigen Fügeprozess beidseitig an die Wärmeaufnahmeabschnitte 25 und 35 der Wärmeleitkörper 20 und 30 gelötet wird. In demselben Fügeprozess härtet ein zuvor zwischen die beiden Wärmetransferabschnitte 26 und 36 der Wärmeleitkörper 20 und 30 gebrachte, elektrisch isolierende Klebstoffschicht 50 stoffschließend aus.

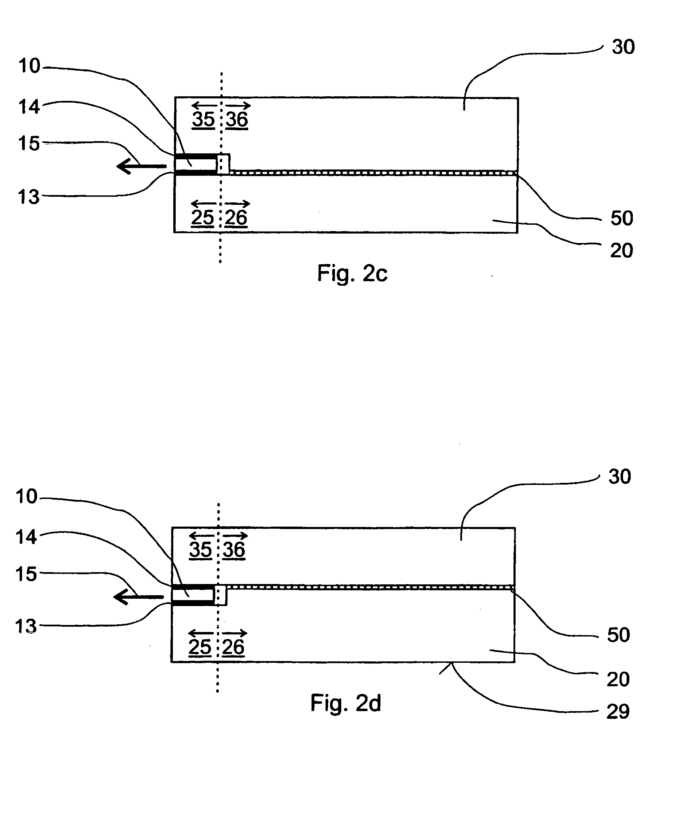

In der zweiten und dritten Variante des zweiten Ausführungsbeispieles besitzt nur einer der Wärmeleitkörper 20 oder 30 eine Erhebung, die sich bis zwischen die Ebenen der Kontaktflächen 11 und 12 erstreckt, beziehungsweise eine Ausnehmung, die der Aufnahme des Laserdiodenbarrens 10 dient. In der in Fig. 2c dargestellten zweiten Variante handelt es sich dabei um den substratseitigen Wärmeleitkörper 30; in der in Fig. 2d dargestellten dritten Variante handelt es sich dabei um den epitaxieseitigen Wärmeleitkörper 20. Diese Varianten bieten den Vorteil, dass der jeweils andere Wärmeleitkörper 30 oder 20 durch entsprechende großflächige Oberflächenbearbeitungsverfahren, beispielsweise Läppen, Polieren oder Diamantfräsen, mit einer hochebenen Wärmeeintritts- beziehungsweise Montagefläche 31 oder 21 für den Laserdiodenbarren 10 bereitgestellt werden kann.

Für den Fachmann sind eine Vielzahl weiterer Ausführungsbeispiele denkbar, die im Einzugsbereich der Erfindung liegen. So ist die Erfindung beispielsweise unabhängig von der Art des zwischen den Wärmeeintrittsabschnitten 25, 35 und dem Halbleiterbauelement 10 bestehenden Stoffschlusses 13,14. Während die beschriebenen Ausführungsbeispiele hierzu den Stoffschluss mittels eines Lotes 13, 14 realisieren, sind ebenso andere stoffschlüssige Fügeverfahren, die ohne ein zusätzlich einzubringendes Fügegut arbeiten, anwendbar. Dazu zählen das Diffusionsbonden oder -schweißen und das eutektische Bonden.

### Bezugszeichenliste:

- 10: Laserdiodenelement
- 11: epitaxieseitige Kontaktfläche
- 12: substratseitige Kontaktfläche
- 13: epitaxieseitiges Lot, epitaxieseitige Lotfuge
- 14: substratseitiges Lot, substratseitige Lotfuge
- 15: Strahlungsemissionsrichtungspfeil
- 20: epitaxieseitiger Wärmeleitkörper
- 21: epitaxieseitige Wärmeeintrittsfläche
- 22: epitaxieseitige Wärmetransferfläche
- 25: epitaxieseitiger Wärmeaufnahmeabschnitt
- 26: epitaxieseitiger Wärmetransferabschnitt
- 30: substratseitiger Wärmeleitkörper
- 31: substratseitige Wärmeeintrittsfläche
- 32: substratseitige Wärmetransferfläche
- 35: substratseitiger Wärmeaufnahmeabschnitt
- 36: substratseitiger Wärmetransferabschnitt
- 40: Metallplatte
- 41: epitaxieseitige Wärmeübergangsfläche
- 42: substratseitige Wärmeübergangsfläche
- 43: epitaxieseitige Lotverbindung
- 44: substratseitige Lotverbindung
- 50: erstes, einen ersten Fügespalt einnehmendes, elektrisch isolierendes Fügemittel
- 51: zweites, einen zweiten Fügespalt einnehmendes, elektrisch isolierendes Fügemittel

## Patentansprüche

1. Wärmeübertragungsvorrichtung mit
- wenigstens einem Halbleiterbauelement (10), insbesondere einem Laserdioden- oder Leuchtdiodenelement,
- einem ersten Wärmeleitkörper (20) und
- wenigstens einem zweiten Wärmeleitkörper (30)
wobei
das Halbleiterbauelement (10)
- auf einer ersten Seite wenigstens eine erste, zumindest abschnittsweise im wesentlichen ebene, Kontaktfläche (11) und
- auf wenigstens einer, der ersten Seite abgewandten, zweiten Seite wenigstens eine zweite, zumindest abschnittsweise im wesentlichen ebene, Kontaktfläche (12) aufweist, und
- zumindest abschnittsweise zwischen dem ersten und dem zweiten Wärmeleitkörper (20 und 30) angeordnet ist,
der erste Wärmeleitkörper (20) einen ersten metallischen Bereich aufweist, der
- hinsichtlich seiner Masse und/ oder seines Volumens den überwiegenden Anteil des ersten Wärmeleitkörpers (20) ausmacht,
- in elektrischer Verbindung mit der ersten Kontaktfläche (11) des Halbleiterbauelementes (10) steht,
- wenigstens einen ersten Wärmeaufnahmeabschnitt (25) mit wenigstens einer ersten Wärmeeintrittsfläche (21)aufweist, die der ersten Kontaktfläche (11) in einer dem Halbleiterbauelement (10) abgewandten Richtung zumindest abschnittsweise gegenüberliegt, und durch wenigstens einen sich in der senkrecht zur ersten Kontaktfläche (11) orientierten Flucht des Halbleiterbauelementes (10) von der ersten Kontaktfläche (11) zur ersten Wärmeeintrittsfläche (21) erstreckenden Stoffschluss mit dem Halbleiterbauelement (10) verbunden ist, sowie
- wenigstens einen ersten Wärmetransferabschnitt (26), der sich in wenigstens einer ersten Wärmetransferrichtung zumindest abschnittsweise parallel zur ersten Kontaktfläche (11) über das Halbleiterbauelement (10) hinaus erstreckt,
der zweite Wärmeleitkörper (30) einen zweiten metallischen Bereich aufweist, der
- hinsichtlich seiner Masse und/ oder seines Volumens den überwiegenden Anteil des zweiten Wärmeleitkörpers (30) ausmacht,
- in elektrischer Verbindung mit der zweiten Kontaktfläche (12) der Halbleiterbauelementes steht,
- wenigstens einen zweiten Wärmeaufnahmeabschnitt (35) mit wenigstens einer zweiten Wärmeeintrittsfläche (31) aufweist, die der zweiten Kontaktfläche (12) in einer dem Halbleiterbauelement (10) abgewandten Richtung zumindest abschnittsweise gegenüberliegt, und durch wenigstens einen sich in der senkrecht zur zweiten Kontaktfläche (12) orientierten Flucht des Halbleiterbauelementes (10) von der zweiten Kontaktfläche (12) zur zweiten Wärmeeintrittsfläche (35) erstreckenden Stoffschluss mit dem Halbleiterbauelement (10) verbunden ist,
sowie
- wenigstens einen zweiten Wärmetransferabschnitt (36), der sich in wenigstens einer, der ersten Wärmetransferrichtung parallelen, zweiten Wärmetransferrichtung zumindest abschnittsweise parallel zur zweiten Kontaktfläche (12) über das Halbleiterbauelement (10) hinaus erstreckt,
wobei
- der zweite metallische Bereich im zweiten Wärmetransferabschnitt dem ersten metallischen Bereich im ersten Wärmetransferabschnitt zumindest abschnittsweise gegenüberliegt,
und
- ein zumindest abschnittsweise zwischen einander gegenüberliegenden Abschnitten der ersten und zweiten metallischen Bereiche angeordneter Fügespalt, über den die Wärmetransferabschnitte des ersten und des zweiten Wärmeleitkörpers (20, 30) miteinander stoffschlüssig verbunden sind, zumindest abschnittsweise wenigstens ein elektrisch isolierendes Fügemittel (50) aufweist
**dadurch gekennzeichnet, dass**
das elektrisch isolierende Fügemittel (50) in wenigstens einem Teilbereich des Fügespalts den dortigen Abstand zwischen dem ersten und dem zweiten metallischen Bereich oder zwischen dem ersten oder dem zweiten metallischen Bereich und wenigstens einem dritten metallischen Bereich eines Zwischenkörpers (40), der zumindest abschnittsweise zwischen dem ersten und zweiten Wärmetransferabschnitt angeordnet ist, wenigstens zur Hälfte stoffschlüssig überbrückt
und
wenigstens einer der dem Fügespalt benachbarten ersten, zweiten oder dritten metallischen Bereiche zumindest teilweise zwischen den Ebenen angeordnet ist, in denen die erste und zweite Kontaktfläche (11) und (12) des Halbleiterbauelementes (10) liegen.

2. Wärmeübertragungsvorrichtung nach Anspruch 1,
**dadurch gekennzeichnet, dass**
das elektrisch isolierende Fügemittel (50) in wenigstens einem Teilbereich des Fügespalts den dortigen Abstand zwischen den metallischen Bereichen vollständig stoffschlüssig überbrückt.

3. Wärmeübertragungsvorrichtung nach Anspruch 1,
**dadurch gekennzeichnet, dass**
das elektrisch isolierende Fügemittel (50) in wenigstens einem Teilbereich des Fügespalts den dortigen Abstand zwischen den metallischen Bereichen bis auf die Dicken von auf den metallischen Bereichen in Angrenzung an den Fügespalt aufgebrachten Haftvermittlungsschichten vollständig stoffschlüssig überbrückt.

4. Wärmeübertragungsvorrichtung nach einem der vorhergehenden Ansprüche,
**dadurch gekennzeichnet, dass**
das elektrisch isolierende Fügemittel (50) wenigstens ein Fügemittel aus der Gruppe der Klebstoffe, Zemente und Glaslote ist.

5. Wärmeübertragungsvorrichtung nach einem der vorhergehenden Ansprüche,
**dadurch gekennzeichnet, dass**
der erste metallische Bereich den ersten Wärmeleitkörper vollständig umfasst und/oder der zweite metallische Bereich den zweiten Wärmeleitkörper vollständig umfasst und/ oder der dritte metallische Bereich den dritten Wärmeleitkörper vollständig umfasst.

6. Wärmeübertragungsvorrichtung nach einem der vorhergehenden Ansprüche,
**dadurch gekennzeichnet, dass**
der erste und der zweite metallische Bereich überwiegend Kupfer enthalten.

7. Wärmeübertragungsvorrichtung nach Anspruch 6,
**dadurch gekennzeichnet, dass**
der dritte metallische Bereich überwiegend Kupfer enthält.

8. Wärmeübertragungsvorrichtung nach einem der Ansprüche 1 bis 5,
**dadurch gekennzeichnet, dass**
der erste und der zweite metallische Bereich überwiegend wenigstens einen Kohlenstoff-Metall-Verbundwerkstoff enthalten.

9. Wärmeübertragungsvorrichtung nach Anspruch 8,
**dadurch gekennzeichnet, dass**
der dritte metallische Bereich überwiegend wenigstens ein Refraktärmetall enthält.

10. Wärmeübertragungsvorrichtung nach einem der vorhergehenden Ansprüche,
**dadurch gekennzeichnet, dass**
wenigstens einer der Wärmeleitkörper (20, 30) wenigstens eine zumindest abschnittsweise im Wärmeeintrittsabschnitt (25, 35) angeordnete oberflächliche Ausnehmung aufweist, deren Bodenfläche zumindest abschnittsweise die Wärmeeintrittsfläche (21, 31) bildet und welche das Halbleiterbauelement (10) zumindest abschnittsweise aufnimmt.

11. Wärmeübertragungsvorrichtung nach Anspruch 10, **dadurch gekennzeichnet, dass** der erste und der zweite Wärmeleitkörper (20 und 30) jeweils wenigstens eine zumindest abschnittsweise im Wärmeeintrittsabschnitt (25, 35) angeordnete oberflächliche Ausnehmung aufweist, deren Bodenfläche zumindest abschnittsweise die Wärmeeintrittsfläche (21, 31) bildet und welche das Halbleiterbauelement (10) zumindest abschnittsweise aufnimmt.

12. Wärmeübertragungsvorrichtung nach einem der vorhergehenden Ansprüche,
**dadurch gekennzeichnet, dass**
sie mit Ausnahme von Wärmesenken, Befestigungsmitteln zur Anbringung elektrischer Anschlüsse, Kurzschlusselementen und/ oder Temperatursensoren aus nicht mehr als den folgenden drei Komponenten besteht: einem Laserdiodenbarren (10), einem ersten Wärmeleitkörper (20) und einem zweiten Wärmeleitkörper (30).

13. Wärmeübertragungsvorrichtung nach einem der Ansprüche 1 bis 11,
**dadurch gekennzeichnet, dass**
der dritte Wärmeleitkörper (40) auf zwei einander gegenüberliegenden Seiten mittels elektrisch isolierender Fügemittel (50, 51) mit den Wärmetransferabschnitten (26, 36) verbunden ist, oder
**dadurch gekennzeichnet, dass**
der dritte Wämeleitkörper (40) auf einer Seite mit einem der Wärmetransferabschnitte (26, 36) mittels eines metallischen Lotes (43, 44) verbunden ist.

14. Wärmeübertragungsvorrichtung nach einem der vorhergehenden Ansprüche,
**dadurch gekennzeichnet, dass**
das Halbleiterbauelement ein Laserdiodenbarren ist, der wenigstens eine optische Achse der Strahlungsemission aufweist, und
die Ausdehnung wenigstens einer der Wärmeleitkörper (20, 30) auf zumindest einer Geraden, die senkrecht zu wenigstens einer der Kontaktflächen (11, 12) des Laserdiodenbarrens in wenigstens einer Ebene liegt, die sich senkrecht zu wenigstens einer der Kontaktflächen (11, 12) des Halbleiterbauelementes und parallel zu der optischen Achse der Strahlungsemission durch den besagten Wärmeleitkörper (20, 30) und den Laserdiodenbarren (10) erstreckt, größer ist als wenigstens eine in der besagten Ebene liegende Erstreckung des Laserdiodenbarrens, die parallel zu wenigstens einer der Kontaktflächen (11, 12) ausgerichtet ist,
wobei bevorzugt
wenigstens eine Erstreckung des elektrisch isolierenden Fügemittels (50) in der besagten Ebene wenigstens doppelt so groß ist wie die wenigstens eine in der besagten Ebene liegende Erstreckung des Laserdiodenbarrens (10), die parallel zu wenigstens einer der Kontaktflächen (11, 12) ausgerichtet ist.

15. Wärmeübertragungsvorrichtung nach einem der vorhergehenden Ansprüche
**dadurch gekennzeichnet, dass**
wenigstens einer der Wärmeleitkörper (20 oder 30) an wenigstens eine Wärmesenke angeschlossen ist, wobei bevorzugt
nur einer der Wärmeleitkörper (20 oder 30) auf einer dem Halbleiterbauelement (10) gegenüberliegenden Seite an wenigstens eine Wärmesenke angeschlossen ist.

## Claims

1. Heat transfer device with
- at least one semiconductor component (10), in particular a laser diode or light-emitting diode element,
- a first heat conducting body (20) and
- at least one second heat conducting body (30),
wherein
the semiconductor component (10) has
- on a first side, at least a first contact surface (11), sections at least of which are substantially flat and
- on at least a second side facing away from the first side, at least a second contact surface (12), sections at least of which are substantially flat and
- sections at least of which are arranged between the first and the second heat conducting body (20 and 30),
the first heat conducting body (20) has a first metallic area which
- with regard to its mass and/or its volume makes up the predominant portion of the first heat conducting body (20),
- is electrically connected to the first contact surface (11) of the semiconductor component (10),
- has at least a first heat absorbing section (25) with at least a first heat entry surface (21) sections at least of which lie opposite the first contact surface (11) in a direction facing away from the semiconductor component (10), and is connected to the semiconductor component (10) by at least one adhesion bond extending in the line, oriented perpendicular to the first contact surface (11), of the semiconductor component (10) from the first contact surface (11) to the first heat entry surface (21), as well as
- at least a first heat transfer section (26) sections at least of which extend beyond the semiconductor component (10) in at least a first heat transfer direction parallel to the first contact surface (11),
the second heat conducting body (30) has a second metallic area which
- with regard to its mass and/or its volume makes up the predominant portion of the second heat conducting body (30),
- is electrically connected to the second contact surface (12) of the semiconductor component,
- has at least a second heat absorbing section (35) with at least a second heat entry surface (31) sections at least of which lie opposite the second contact surface (12) in a direction facing away from the semiconductor component (10), and is connected to the semiconductor component (10) by at least one adhesion bond extending in the line, oriented perpendicular to the second contact surface (12), of the semiconductor component (10) from the second contact surface (12) to the second heat entry surface (35),
as well as
- at least a second heat transfer section (36) sections at least of which extend beyond the semiconductor component (10) in at least a second heat transfer direction parallel to the first heat transfer direction parallel to the second contact surface (12), wherein
- sections at least of the second metallic area in the second heat transfer section lie opposite the first metallic area in the first heat transfer section,
and
- a joining gap, via which the heat transfer sections of the first and of the second heat conducting body (20, 30) are connected by adhesion, and sections at least of which are arranged between opposing sections of the first and second metallic areas, has at least in sections at least one electrically insulating joining agent (50) **characterized in that**
the electrically insulating joining agent (50), in at least one part-area of the joining gap, bridges by adhesion at least half the distance there between the first and the second metallic area or between the first or the second metallic area and at least a third metallic area of an intermediate body (40), which is arranged at least in sections between the first and second heat transfer section,
and
at least one first, second or third metallic area adjacent to the joining gap is arranged at least partly between the planes in which the first and second contact surface (11) and (12) of the semiconductor component (10) lie.

2. Heat transfer device according to claim 1,
**characterized in that**
in at least one part-area of the joining gap, the electrically insulating joining agent (50) completely bridges the distance there between the metallic areas by adhesion.

3. Heat transfer device according to claim 1,
**characterized in that**
in at least one part-area of the joining gap, the electrically insulating joining agent (50) completely bridges the distance there between the metallic areas by adhesion up to the thicknesses of adhesion-promoting layers applied to the metallic areas adjacent to the joining gap.

4. Heat transfer device according to one of the previous claims,
**characterized in that**
the electrically insulating joining agent (50) is at least one joining agent from the group of adhesives, cements and glass solders.

5. Heat transfer device according to one of the previous claims,
**characterized in that**
the first metallic area completely covers the first heat conducting body and/or the second metallic area completely covers the second heat conducting body and/or the third metallic area completely covers the third heat conducting body.

6. Heat transfer device according to one of the previous claims,
**characterized in that**
the first and the second metallic area contain predominantly copper.

7. Heat transfer device according to claim 6,
**characterized in that**
the third metallic area contains predominantly copper.

8. Heat transfer device according to one of claims 1 to 5,
**characterized in that**
the first and the second metallic area contain predominantly at least one carbon-metal composite.

9. Heat transfer device according to claim 8,
**characterized in that**
the third metallic area contains predominantly at least one refractory metal.

10. Heat transfer device according to one of the previous claims,
**characterized in that**
at least one of the heat conducting bodies (20, 30) has at least one surface recess, sections at least of which are arranged in the heat entry section (25, 35), sections at least of the base of which form the heat entry surface (21, 31) and sections at least of which house the semiconductor component (10).

11. Heat transfer device according to claim 10, **characterized in that** the first and the second heat conducting bodies (20 and 30) each have at least one surface recess, sections at least of which are arranged in the heat entry section (25, 35), sections at least of the base of which form the heat entry surface (21, 31) and sections at least of which house the semiconductor component (10).

12. Heat transfer device according to one of the previous claims,
**characterized in that**
with the exception of heat sinks, fixing means for applying electrical connections, short-circuit elements and/or temperature sensors, it consists of no more than the following three components: a laser diode bar (10), a first heat conducting body (20) and a second heat conducting body (30).

13. Heat transfer device according to one of claims 1 to 11,
**characterized in that**
the third heat conducting body (40) is connected on two opposite sides to the heat transfer sections (26, 36) by means of electrically insulating joining agents (50, 51), or **characterized in that**
the third heat conducting body (40) is connected on one side to one of the heat transfer sections (26, 36) by means of a metallic solder (43, 44).

14. Heat transfer device according to one of the previous claims,
**characterized in that**
the semiconductor component is a laser diode bar which has at least one optical axis of radiation emission, and
the extension of at least one of the heat conducting bodies (20, 30) on at least one straight line which lies perpendicular to at least one of the contact surfaces (11, 12) of the laser diode bar in at least one plane which extends perpendicular to at least one of the contact surfaces (11, 12) of the semiconductor component and parallel to the optical axis of radiation emission through said heat conducting bodies (20, 30) and the laser diode bar (10), is greater than at least one extension of the laser diode bar lying in the said plane, which is aligned parallel to at least one of the contact surfaces (11, 12),
wherein preferably at least one extension of the electrically insulating joining agent (50) in the said plane is at least twice as large as the at least one extension of the laser diode bar (10) lying in the said plane, which is aligned parallel to at least one of the contact surfaces (11, 12).

15. Heat transfer device according to one of the previous claims,
**characterized in that**
at least one of the heat conducting bodies (20 or 30) is connected to at least one heat sink,
wherein preferably only one of the heat conducting bodies (20 or 30) is connected to at least one heat sink on a side opposite the semiconductor component (10).

## Revendications

1. Dispositif de transfert de chaleur avec
- au moins un composant semi-conducteur (10), en particulier un élément à diode laser ou à diode électroluminescente,
- un premier corps conducteur de la chaleur (20) et
- au moins un deuxième corps conducteur de la chaleur (30),
sachant que
le composant semi-conducteur (10) comporte
- sur un premier côté, au moins une première surface de contact (11), au moins par endroits sensiblement plane et
- sur au moins un deuxième côté détourné du premier côté, au moins une deuxième surface de contact (12), au moins par endroits sensiblement plane, et
- est disposé au moins par endroits entre le premier et le deuxième corps conducteur de la chaleur (20 et 30),
le premier corps conducteur de la chaleur (20) comportant une première zone métallique qui,
- du point de vue de sa masse et/ou de son volume, constitue la part prépondérante du premier corps conducteur de la chaleur (20),
- se trouve en contact électrique avec la première surface de contact (11) du composant semi-conducteur (10),
- comporte au moins un premier tronçon de réception de chaleur (25) avec au moins une première surface d'entrée de la chaleur (21), qui se trouve au moins par endroits en face de la première surface de contact (11) dans une direction détournée du composant semi-conducteur (10), et est relié par au moins une continuité de la matière, se trouvant dans l'alignement, orienté perpendiculairement à la première surface de contact (11) du composant semi-conducteur (10), de la première surface de contact (11) à la première surface d'entrée de la chaleur (21), au composant semi-conducteur (10), ainsi que
- au moins un premier tronçon de transfert de chaleur (26) qui s'étend dans au moins une première direction de transfert de chaleur, au moins par endroits, parallèlement à la première surface de contact (11), au-delà du composant semi-conducteur (10),
le deuxième corps conducteur de la chaleur (30) comprenant une deuxième zone métallique qui,
- du point de vue de sa masse et/ou de son volume, constitue la part prépondérante du deuxième corps conducteur de la chaleur (30),
- se trouve en contact électrique avec la deuxième surface de contact (12) du composant semi-conducteur,
- comporte au moins un deuxième tronçon de réception de chaleur (35) avec au moins une deuxième surface d'entrée de la chaleur (31), qui se trouve au moins par endroits en face de la deuxième surface de contact (12) dans une direction détournée du composant semi-conducteur (10), et est relié par au moins une continuité de la matière, se trouvant dans l'alignement, orienté perpendiculairement à la deuxième surface de contact (12) du composant semi-conducteur (10), de la deuxième surface de contact (12) à la deuxième surface d'entrée de la chaleur (35), au composant semi-conducteur (10),
ainsi que
- au moins un deuxième tronçon de transfert de chaleur (36), qui s'étend dans au moins une deuxième direction de transfert de chaleur, parallèle à la première direction de transfert de chaleur, au moins par endroits, parallèlement à la deuxième surface de contact (12), au-delà du composant semi-conducteur (10),
sachant que
- la deuxième zone métallique dans le deuxième tronçon de transfert de chaleur se trouve au moins par endroits en face de la première zone métallique dans le premier tronçon de transfert de chaleur,
et
- qu'une fente de jointure disposée au moins par endroits entre des tronçons se trouvant face à face des premier et deuxième tronçons de transfert de chaleur, par laquelle les tronçons de transfert de chaleur du premier et du deuxième corps conducteur de la chaleur (20, 30) sont reliés ensemble par continuité de matière, comporte au moins par endroits au moins un agent de jointure (50) électriquement isolant,
**caractérisé en ce que**
l'agent de jointure (50) électriquement isolant ponte par continuité de matière, au moins à moitié, dans au moins une zone partielle de la fente de jointure, la distance à cet endroit entre la première et la deuxième zone métallique ou entre la première ou la deuxième zone métallique et au moins une troisième zone métallique d'un corps intermédiaire (40) qui est disposé au moins par endroits entre le premier et le deuxième tronçon de transfert de la chaleur
et
**en ce qu'**au moins une des première, deuxième ou troisième zones métalliques voisines de la fente de jointure est disposée au moins en partie entre les plans dans lesquels se trouvent la première et la deuxième surface de contact (11) et (12) du composant semi-conducteur (10).

2. Dispositif de transfert de chaleur selon la revendication 1,
**caractérisé en ce que**
l'agent de jointure (50) électriquement isolant ponte complètement par continuité de matière dans au moins une zone partielle de la fente de jointure la distance en cet endroit entre les zones métalliques.

3. Dispositif de transfert de chaleur selon la revendication 1,
**caractérisé en ce que**
l'agent de jointure (50) électriquement isolant ponte complètement par continuité de matière dans au moins une zone partielle de la fente de jointure la distance en cet endroit entre les zones métalliques, à l'exception des épaisseurs des couches d'agent de pontage appliquées sur les zones métalliques à la frontière de la fente de jointure.

4. Dispositif de transfert de chaleur selon l'une quelconque des revendications précédentes,
**caractérisé en ce que**
l'agent de jointure (50) électriquement isolant est au moins un agent de jointure du groupe des colles, des ciments ou des verres à bas point de fusion.

5. Dispositif de transfert de chaleur selon l'une quelconque des revendications précédentes,
**caractérisé en ce que**
la première zone métallique enserre totalement le premier corps de conduction thermique et/ou la deuxième zone métallique enserre totalement le deuxième corps de conduction thermique et/ou la troisième zone métallique enserre totalement le troisième corps de conduction thermique.

6. Dispositif de transfert de chaleur selon l'une quelconque des revendications précédentes,
**caractérisé en ce que**
la première et la deuxième zone métallique contiennent principalement du cuivre.

7. Dispositif de transfert de chaleur selon la revendication 6,
**caractérisé en ce que**
la troisième zone métallique contient principalement du cuivre.

8. Dispositif de transfert de chaleur selon l'une quelconque des revendications 1 à 5,
**caractérisé en ce que**
la première et la deuxième zone métallique contiennent principalement au moins un matériau composite carbone-métal.

9. Dispositif de transfert de chaleur selon la revendication 8,
**caractérisé en ce que**
la troisième zone métallique contient principalement au moins un métal réfractaire.

10. Dispositif de transfert de chaleur selon l'une quelconque des revendications précédentes,
**caractérisé en ce que**
au moins un des corps conducteurs de la chaleur (20, 30) comporte au moins un évidement superficiel, disposé au moins par endroits dans le tronçon de réception de chaleur (25, 35), dont la surface du fond forme au moins par endroits la surface d'entrée de la chaleur (21, 31) et qui loge au moins par endroits le composant semi-conducteur (10).

11. Dispositif de transfert de chaleur selon la revendication 10, **caractérisé en ce que** le premier et le deuxième corps conducteur de la chaleur (20, 30) comportent chacun au moins un évidement superficiel disposé au moins par endroits dans le tronçon de réception de chaleur (25, 35), dont la surface du fond forme au moins par endroits la surface d'entrée de la chaleur (21, 31) et qui loge au moins par endroits le composant semi-conducteur (10).

12. Dispositif de transfert de chaleur selon l'une quelconque des revendications précédentes,
**caractérisé en ce**
**qu'**à l'exception des puits de chaleur, des moyens de fixation pour mettre des branchements électriques, des éléments de court-circuit et/ou des sondes de température, il ne consiste pas en davantage que les trois composants suivants : une barre de diode à laser (10), un premier corps conducteur de la chaleur (20) et un deuxième corps conducteur de la chaleur (30).

13. Dispositif de transfert de chaleur selon l'une quelconque des revendications 1 à 11,
**caractérisé en ce que**
le troisième corps conducteur de la chaleur (40) est relié sur deux côtés opposés, au moyen d'agents de jointure (50, 51) électriquement isolants, aux tronçons de transfert de chaleur (26, 36), ou
**caractérisé en ce que**
le troisième corps conducteur de la chaleur (40) est relié sur un côté à un des tronçons de transfert de chaleur (26, 36) au moyen d'un métal d'apport de brasage (43, 44)

14. Dispositif de transfert de chaleur selon l'une quelconque des revendications précédentes,
**caractérisé en ce que**
le composant semi-conducteur est une barre de diode à laser qui présente au moins un axe optique de l'émission de rayonnement, et
**en ce que** l'étendue d'au moins un des corps conducteurs de la chaleur (20, 30) sur au moins une droite qui se trouve perpendiculairement à au moins une des surfaces de contact (11, 12) de la barre de diode à laser dans au moins un plan qui s'étend perpendiculairement à au moins une des surfaces de contact (11, 12) du composant semi-conducteur et parallèlement à l'axe optique de l'émission de rayonnement à travers ledit corps conducteur de la chaleur (20, 30) et la barre de diode à laser (10), est plus grande qu'au moins une extension de la barre de diode à laser se trouvant dans ledit plan, qui est orientée parallèlement à au moins une des surfaces de contact (11, 12),
sachant que, de préférence, au moins une extension de l'agent de jointure (50) électriquement isolant dans ledit plan est au moins deux fois plus grande que ladite au moins une extension de la barre de diode à laser (10) se trouvant dans ledit plan, qui est orientée parallèlement à au moins une des surfaces de contact (11, 12).

15. Dispositif de transfert de chaleur selon l'une quelconque des revendications précédentes,
**caractérisé en ce que**
au moins un des corps conducteurs de la chaleur (20, 30) est raccordé à au moins un puits de chaleur, sachant que, de préférence, un seulement des corps conducteurs de la chaleur (20, 30) est raccordé d'un côté opposé au composant semi-conducteur (10) à au moins un puits de chaleur.
